Europäisches Patentamt

European Patent Office

Office européen des brevets

(19)

(11) **EP 0 729 582 B1**

(12) # FASCICULE DE BREVET EUROPEEN

| | |
|---|---|
| (45) Date de publication et mention de la délivrance du brevet:<br>**28.07.1999 Bulletin 1999/30** | (51) Int Cl.⁶: **G01P 3/487**, H01L 43/06 |
| (21) Numéro de dépôt: **95931255.4** | (86) Numéro de dépôt international:<br>**PCT/FR95/01191** |
| (22) Date de dépôt: **15.09.1995** | (87) Numéro de publication internationale:<br>**WO 96/08727 (21.03.1996 Gazette 1996/13)** |

(54) **CAPTEUR INCREMENTAL DE VITESSE ET/OU DE POSITION**

INKREMENTALER GESCHWINDIGKEITS- UND / ODER LAGEGEBER

SPEED AND/OR POSITION INCREMENTAL SENSOR

<table>
<tr><td>

(84) Etats contractants désignés:<br>**CH DE ES GB IT LI**

(30) Priorité: **16.09.1994 FR 9411078**<br>**19.06.1995 FR 9507306**

(43) Date de publication de la demande:<br>**04.09.1996 Bulletin 1996/36**

(73) Titulaire: **MOVING MAGNET TECHNOLOGIES S.A.**<br>**25000 Besançon (FR)**

</td><td>

(72) Inventeur: **OUDET, Claude**<br>**F-25000 Besançon (FR)**

(74) Mandataire: **Pernez, Helga et al**<br>**Breese-Majerowicz,**<br>**3, avenue de l'Opéra**<br>**75001 Paris (FR)**

(56) Documents cités:<br>DE-A- 3 638 622    US-A- 5 250 925

</td></tr>
</table>

## Description

La présente invention concerne un capteur incrémental de vitesse et/ou de position, mettant en oeuvre une sonde sensible au sens et à l'amplitude d'un champ magnétique, par exemple une sonde de Hall, pour la détection de vitesse et/ou de position, susceptible de détecter des vitesses jusqu'à une valeur inférieure correspondant à une vitesse nulle.

La sonde magnétique délivre un signal électrique fonction du champ magnétique la traversant. Les capteurs de vitesse de l'état de la technique sont conçus de manière à ce que le déplacement d'un organe mobile provoque une variation du champ magnétique. Dans la suite de la description, on utilisera le terme de "sonde de Hall" pour désigner un capteur sensible au sens et à l'amplitude du champ magnétique, délivrant un signal électrique fonction du sens et de l'amplitude du champ magnétique le traversant, sans que ce terme ne doive être interprété de manière restrictive.

Un premier type de capteurs à sonde de Hall comporte un organe mobile présentant une alternance de pôles magnétiques Nord et Sud. La sonde de Hall est associée à un circuit électronique possédant une sortie logique qui prend un premier état quand le comparateur situé à la sortie de la sonde de Hall fournit un signal supérieur à un seuil prédéterminé positif, et un second état quand la sonde de Hall fournit un signal inférieur à un seuil prédéterminé négatif. Un tel dispositif est décrit par exemple dans le brevet français FR2648914. De tels capteurs sont sensibles à différentes perturbations extérieures et les dimensions de l'organe mobile sont limitées par son coût.

Un autre type de capteurs à sonde de Hall est constitué par un organe mobile denté en un matériau magnétique doux, un aimant permanent et une sonde de Hall placée entre la surface dentée de l'organe mobile et l'aimant permanent. De tels capteurs sont par exemple décrits dans le certificat d'utilité FR8209884 ou le brevet américain US5250925. De tels capteurs sont mal adaptés à l'utilisation d'une surface dentée de faible pas. Pour réduire le pas de détection, il est donc nécessaire de rapporcher l'aimant de la surface dentée, ce qui crée des contraintes mécaniques difficiles à repecter dans le cas de fabrication en très grandes séries.

De tels capteurs sont surtout mal adaptés à la détection de faibles vitesses, et plus encore à la détection de position, par suite de la valeur moyenne élevée du champ par rapport à l'amplitude de sa modulation. Cette valeur moyenne et sa traduction en signal électrique présente une forte sensibilité à diverses tolérances difficiles à maîtriser ou à compenser, notamment :

- les caractéristiques B(H) de l'aimant dans le deuxième quadrant;
- les tolérances sur les dimensions de l'aimant ;
- les coefficients de température de l'induction rémanente Br et du champ coercitif Hc de l'aimant ;
- la plus ou moins bonne saturation de l'aimant lors de l'aimantation ;
- les tolérances sur la géométrie de la denture ;
- la distance entre l'aimant et la denture ;
- les tolérances sur la position de la sonde de Hall ;
- l'offset et les divers coefficients de température de la sonde de Hall.

Dans ce qui suit, on désignera par "plan YOZ" le plan de symétrie de la denture de l'organe mobile. OY désignera la direction de déplacement de l'organe mobile. O désigne le point sur l'enveloppe des sommets des dents situé sur la droite passant par le centre de la sonde de Hall et de l'aimant. Lorsque l'organe mobile est une roue dentée, le centre O' de la roue dentée se trouve sur l'axe OX.

Le plan XOZ désignera le plan de symétrie de la dent, ou du creux de dent se trouvant en regard de la sonde de Hall et de l'aimant permanent. OZ désigne l'axe passant par la sonde de Hall, l'aimant et la surface dentée. OX est généralement un axe radial.

Dans le cas d'un capteur rotatif, XOY est un plan tangent à la surface d'une roue dentée constituant l'organe mobile, et OX est généralement un axe parallèle à la génératrice de la denture.

Dans le cas d'un capteur linéaire, XOY est le plan moyen de la surface dentée.

Le circuit électronique de traitement du signal fourni par la sonde de Hall, disposée pour détecter la composante du champ suivant OZ, peut comporter un comparateur sensible à l'amplitude de ce signal qui reste de signe constant, avec les inconvénients déjà cités pour ce qui est des fluctuations de sa valeur moyenne. Mais le plus souvent le circuit électronique comporte avant le comparateur un filtre passe-haut éliminant la valeur moyenne du signal pour ne laisser passer que sa modulation. A défaut de ce filtre, la modulation peut être suffisante sans pour autant que le comparateur ne soit activé.

On a proposé dans l'état de la technique de remédier aux inconvénients qui apparaissent à vitesse faible, ou à l'impossibilité de fonctionner en détecteur de position par différentes solutions qui ne s'avèrent pas totalement satisfaisantes.

Une première solution est décrite dans le brevet PCT WO87/06348 relatif à un capteur détectant non seulement la variation de champ magnétique, mais aussi sa valeur moyenne, ce qui nécessite la mise en oeuvre d'un filtre qui ne fonctionne pas aux très faibles vitesses. Même pour une vitesse atteignant soudainement une valeur élevée, le filtre ne donne la valeur moyenne qu'au bout de plusieurs périodes. Il peut donc y avoir des erreurs de détection au démarrage.

Une deuxième solution décrite dans le brevet BE0363512, consiste à mettre en oeuvre deux sondes de Hall pour former un capteur différentiel.

Ces deux solutions nécessitent des circuits électroniques complexes, ou des puces de grande surface, ce qui augmente sensiblement le coût des capteurs, particulièrement dans le cas de la mise en oeuvre d'un capteur différentiel.

Une troisième solution est décrite dans le brevet américain US4481469, qui décrit un capteur qui détecte la composante tangentielle du champ, selon l'axe OY. Cette composante change de signe au cours du déplacement d'une valeur correspondant à un pas, et sa valeur moyenne est nulle. Cette solution permet certes de remédier en partie aux inconvénients des capteurs conformes aux deux solutions précédentes. Toutefois, un tel capteur n'est pas non plus totalement satisfaisant. L'amplitude de la composante du champ magnétique détectée par la sonde de Hall est faible, surtout près de l'aimant. De plus, la sonde de Hall devant être disposée dans le plan XOZ et non plus dans un plan parallèle à XOY, la distance entre l'aimant et la denture doit être augmentée par rapport aux autres solutions. Cette augmentation de la distance a également une incidence défavorable sur l'amplitude du champ détecté, et le capteur est de ce fait sensible aux champs magnétiques parasites.

D'autres solutions concernent des capteurs dans lesquels la sonde de Hall est placée en face d'une fente ménagée dans une pièce métallique. Le brevet US5321355 concerne un capteur de position mettant en oeuvre une sonde à effet Hall. La sonde à effet Hall est disposée à proximité d'une pièce métallique présentant une fente. Dans le capteur selon cet état de la technique, la fente prévue dans la pièce métallique est destinée à convertir l'induction élevée de l'aimant permanent en une induction faible compatible avec une sonde de Hall.

On connaît également dans l'état de la technique le brevet allemand DE3638622 dans lequel la sonde de Hall est dans le canal d'un aimant annulaire. Un aimant annulaire crée un champ présentant une zone de champ nul disposée sensiblement sur l'axe central de l'aimant, en un point localisé à l'extérieur de l'aimant annulaire. Ce point est d'autant plus reculé par rapport au plan frontal de l'aimant annulaire que le diamètre du canal central est important et que l'aimant est court. Par exemple pour un aimant de diamètre 10mm, longueur 4mm, le point singulier est à 1,2 mm du plan frontal pour un diamètre intérieur de 6mm, et encore à plus de 0,6mm pour un diamètre de 3mm. Or ce diamètre est déjà trop petit pour permettre une réalisation économique sur une longueur de 4mm. Il est aussi très défavorable d'éloigner la masse de l'aimant de l'axe OZ sur lequel on veut engendrer la modulation maximale ; or cela se produit inévitablement avec les aimants tubulaires de l'état de l'art antérieur. En d'autres termes il faut réduire autant que possible le volume du trou par rapport au volume de l'aimant, ce qui est bien loin d'être le cas dans des réalisations connues. Dans les capteurs à aimant et sonde de Hall on a tout intérêt à utiliser des sondes de Hall aussi minces que possible pour réduire l'entrefer entre l'aimant et la surface dentée, par exemple la HZ106C de Ashl d'une épaisseur totale de 0,6mm dont la surface sensible est à 0,2mm de la face inférieure. Le point de champ nul étant disposé trop loin de la face de l'aimant, la sonde de Hall doit être éloignée de l'aimant ce qui nécessite une augmentation d'entrefer et entraîne une réduction de sensibilité du capteur. Le capteur selon cet état de la technique n'est donc pas compatible avec une réelle miniaturisation. De plus, le réglage de la position exacte de la sonde de Hall par rapport à la zone d'annulation de la composante du champ suivant OZ est extrêmement délicat, le gradient de champ étant élevé, et ce réglage est peu compatible avec les moyens proposés.

Le brevet US5210489 de l'art antérieur décrit un dispositif comportant un aimant présentant un sillon dont le but est d'homogénéiser le champ et de rendre les lignes de flux parallèles. L'homogénéisation de la zone de champ homogène est un but fondamentalement différent de celui de la présente invention, dans laquelle on recherche un champ nul dans la zone dans laquelle est placée la sonde de Hall.

L'objet de la présente invention est de remédier aux inconvénients des capteurs selon les différentes solutions de l'état de la technique en proposant un capteur miniature de faible prix de fabrication, permettant la détection de vitesses nulles (fonctionnement en capteur de position), peu sensible aux champs magnétiques parasites par suite de la mise en oeuvre d'une géométrie engendrant un champ magnétique variant en signe et de manière suffisante en amplitude, et mettant en oeuvre un nombre de pièces aussi réduit que possible.

A cet effet, le capteur selon l'invention concerne un capteur incrémental de position et/ou de vitesse, du type comportant un élément mobile en un matériau doux présentant au moins une dent mobile dans une direction parallèle à un axe OY en regard d'un aimant permanent aimanté selon un axe OZ sensiblement perpendiculaire à l'axe OY et une sonde sensible au sens et à l'intensité d'un champ magnétique, telle qu'une sonde de Hall, disposée dans l'entrefer compris entre l'aimant et la dent de l'élément mobile de telle sorte que son axe de plus grande sensibilité soit sensiblement orienté selon l'axe OZ, le capteur étant dimensionné de telle sorte que la sonde de Hall est située à proximité d'un point singulier de l'axe OZ (point de champ nul), caractérisé en ce que la sonde de Hall est située en un point où la valeur moyenne du champ magnétique suivant OZ au cours du déplacement de l'élément mobile est sensiblement égale au champ entraînant le basculement du circuit électronique de traitement du signal délivré par la sonde de Hall .

Cette valeur de basculement du circuit électronique intégré associé à la sonde correspond à un champ faible, proche de zéro, et dépend du circuit intégré choisi. Sa valeur absolue est préférentiellement comprise entre 0 et 20 mT, plus particulièrement entre 0 et 8 mT.

La sonde de Hall est placée en dehors du volume défini par l'aimant de façon à permettre une miniaturisation du capteur et particulièrement du trou de l'aimant.

Le plan de la couche de Hall de la sonde de Hall est disposé entre le plan passant par la face frontale de l'aimant la plus proche de l'élément mobile, et le plan parallèle tangent à l'élément mobile, à une distance du plan frontal de l'aimant au moins égale à l'épaisseur de l'enveloppe de protection de la couche de Hall.

L'aimant présente une cavité située à proximité de l'axe perpendiculaire à l'axe de déplacement de l'élément mobile passant par la sonde de Hall.

On entendra par "dent" au sens du présent brevet tout profil engendrant un entrefer variable sur l'axe OZ. Ce profil peut être régulier ou non, concave ou convexe, saillant par rapport à une surface généralement régulière ou formé par une encoche.

Selon une première variante, la cavité est un trou de très petit diamètre traversant l'aimant permanent.

Selon une autre variante, l'aimant est constitué par un aimant de forme discale percé au moins partiellement par une cavité cylindrique coaxiale.

Avantageusement, la sonde de Hall est positionnée à une ordonnée z sur l'axe OZ telle que l'induction définie par la relation suivante

$$\frac{B_{Total}}{B_r} = \frac{B_{aimant\_plein}}{B_r} - \frac{B_{aimant\_virtuel}}{B_r} + \frac{B_{aimant\_bouchon}}{B_r}$$

soit sensiblement égale à la valeur moyenne de basculement du circuit électronique intégré associé à la sonde de Hall lorsque l'entrefer augmente,

où :

- $B_{total}$ est la composante de l'induction suivant OZ ;
- l'origine O des axes à partir de laquelle est mesurée la distance z se trouve sur la face de l'aimant en regard de la denture ;
- $B_r$ désigne l'induction rémanente ;
- $B_{aimant\_plein}$ désigne l'induction d'un aimant virtuel non percé, notamment cylindrique, dont les dimensions extérieures correspondent aux dimensions extérieures de l'aimant permanent ;
- $B_{aimant\_virtuel}$ désigne l'induction d'un aimant virtuel dont les dimensions extérieures correspondent aux dimensions intérieures de la cavité ;
- $B_{aimant\_bouchon}$ désigne l'induction d'un aimant virtuel dont la section correspond à la section intérieure de la cavité, et dont la hauteur correspond à la différence entre l'aimant réel et la profondeur de la cavité.

Selon une autre variante avantageuse, la sonde de Hall est positionnée à une ordonnée z sur l'axe OZ telle que l'induction satisfait à :

$$\frac{B_{basculement}}{B_r} \cong \frac{1}{2}\left[\frac{z+2L}{\sqrt{R^2+(z+2L)^2}} - \frac{z}{\sqrt{R^2+z^2}} - \frac{z+2L}{\sqrt{r^2+(z+2L)^2}} + \frac{z}{\sqrt{r^2+z^2}} + \frac{(z+2l)}{\sqrt{r^2+(z+2l)^2}} - \frac{z}{\sqrt{r^2+z^2}}\right]$$

où :

- $B_{basculement}$ désigne la valeur du champ de basculement du circuit intégré de traitement du signal de la sonde de Hall ;
- $B_r$ désigne l'induction rémanente ;
- l désigne la différence entre l'épaisseur de l'aimant et la profondeur de la cavité (l est nul dans le cas d'un trou traversant l'aimant) ;
- L désigne l'épaisseur de l'aimant dans le cas où l'aimant est associé à une culasse de grande dimension, la culasse jouant alors le rôle de miroir magnétique. Si l'aimant n'est pas associé à une culasse, l'épaisseur de l'aimant est 2L ;
- z désigne l'ordonnée de la sonde de Hall mesurée à partir d'une origine située sur la face de l'aimant en regard de la denture ;
- R désigne le rayon extérieur de l'aimant ;
- r désigne le rayon de la cavité ou du trou cylindrique.

Selon un premier mode de réalisation pour la détection de déplacements rotatifs, l'élément mobile est une roue dentée.

Selon un deuxième mode de réalisation pour la détection de déplacements linéaires, l'élément mobile est une crémaillère.

De préférence, les dimensions transversales du trou traversant l'aimant sont comprises entre 0,8 et 1,8 mm, et de préférence entre 0,8 et 1,3 mm.

Avantageusement, la forme de l'aimant correspond à la forme des dentures. Une denture de forme rectangulaire s'adaptera à un aimant rectangulaire.

Selon un mode de réalisation préféré, l'aimant, la sonde de Hall et les circuits électroniques associés sont intégrés dans un boîtier en matière plastique réalisé par surmoulage. Ce mode de réalisation permet de positionner précisément la sonde par rapport à l'aimant et d'augmenter le jeu entre cet ensemble surmoulé et la roue dentée en raison de la réduction d'épaisseur ou de l'absence de plastique entre la sonde de Hall et l'aimant.

L'invention sera mieux comprise à la lecture de la description qui suit, faisant référence aux dessins annexés où :

- la figure 1 représente une vue schématique de l'organe mobile ;
- la figure 2 représente une vue de la distribution de champ dans le plan YOZ au voisinage du trou pratiqué dans l'aimant en l'absence de dent ;
- la figure 3 représente une vue de la distribution de champ dans le plan YOZ au voisinage du trou pratiqué dans l'aimant en présence de dent ;
- la figure 4 représente une vue en détail des dents d'une roue ;
- la figure 5 représente une vue en perspective d'un autre mode de réalisation de l'aimant ;
- la figure 6 représente une vue d'un troisième mode de réalisation de l'aimant,
- la figure 7 représente une vue en coupe d'un quatrième mode de réalisation ,
- la figure 8 représente la courbe induction/distance de l'aimant mis en oeuvre dans le quatrième mode de réalisation.

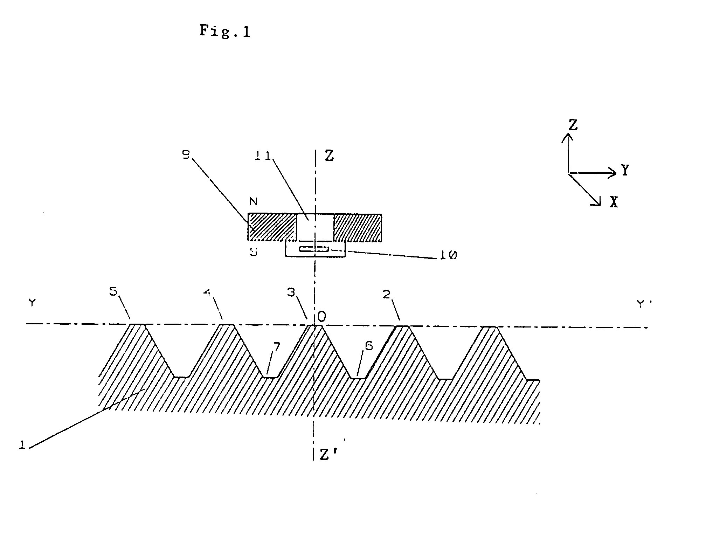

La figure 1 représente une vue schématique du capteur dans un mode de réalisation pour la détection de vitesse et de position angulaire.

Le capteur comporte une roue dentée (1) présentant une pluralité de dents (2, 3, 4, 5) et de creux intercalaires (6, 7, 8). La roue (1) est réalisée en matériau magnétique doux.

Le capteur comporte en outre un aimant (9) aimanté suivant l'axe radial ZOZ'. L'aimant présente donc l'un des pôles dirigés en direction de la roue dentée (1) et l'autre pôle dans la direction opposée. Une sonde de Hall (10) est disposée sur l'axe ZOZ', entre la roue dentée (1) et l'aimant permanent (9).

L'aimant (9) est un aimant disque de diamètre D et d'épaisseur L. A titre d'exemple, l'aimant est de type samarium-cobalt d'un diamètre de 7 millimètres et d'une épaisseur L de 2 millimètres.

L'aimant (9) est percé d'un trou circulaire (11) d'un diamètre de 1,4 millimètres.

La distance moyenne entre le sommet d'une dent et l'aimant est de 1,6 millimètres et la hauteur des dents est de l'ordre de 3,5 millimètres.

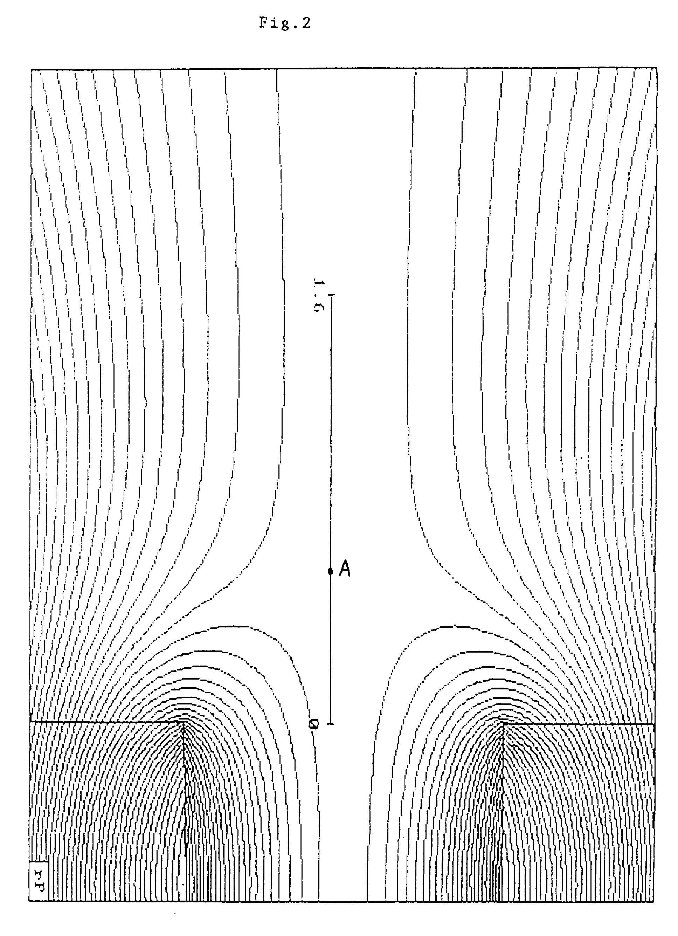

La figure 2 représente une simulation de la distribution de champ au voisinage du trou (11) de l'aimant disque (9). Sur l'axe ZOZ', le champ change de signe de part et d'autre d'un point singulier A.

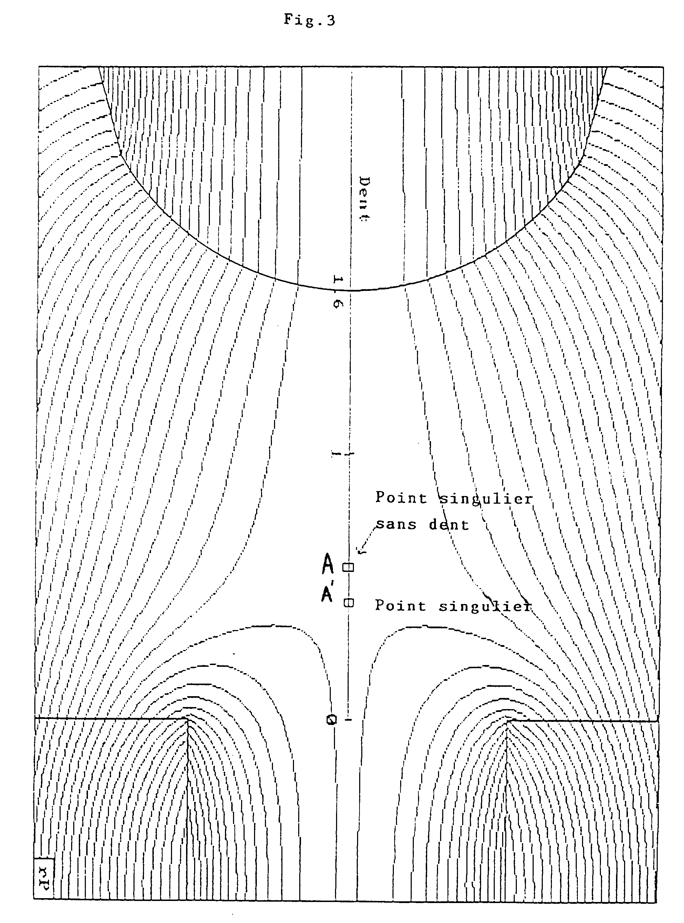

La figure 3 montre la distribution de champ dans la même région avec une dent distante de 1,6 millimètres de l'aimant (9). Le point singulier A' est plus proche de l'aimant (9) que dans la situation précédente.

La sonde de Hall (10) est placée de préférence dans la zone comprise entre le point singulier A correspondant à l'absence de dent, et le point singulier A' correspondant à la présence d'une dent. De ce fait, la sonde de Hall détectera une variation du signe du champ lors du déplacement de l'organe mobile, en l'occurrence des dents de la roue dentée (1).

La variation du champ détectée par la sonde de Hall (10) varie autour d'une valeur nulle du fait du perçage de l'aimant (9) conduisant à une distribution de champ dans laquelle le sens du champ détecté change de signe suivant la position de la dent.

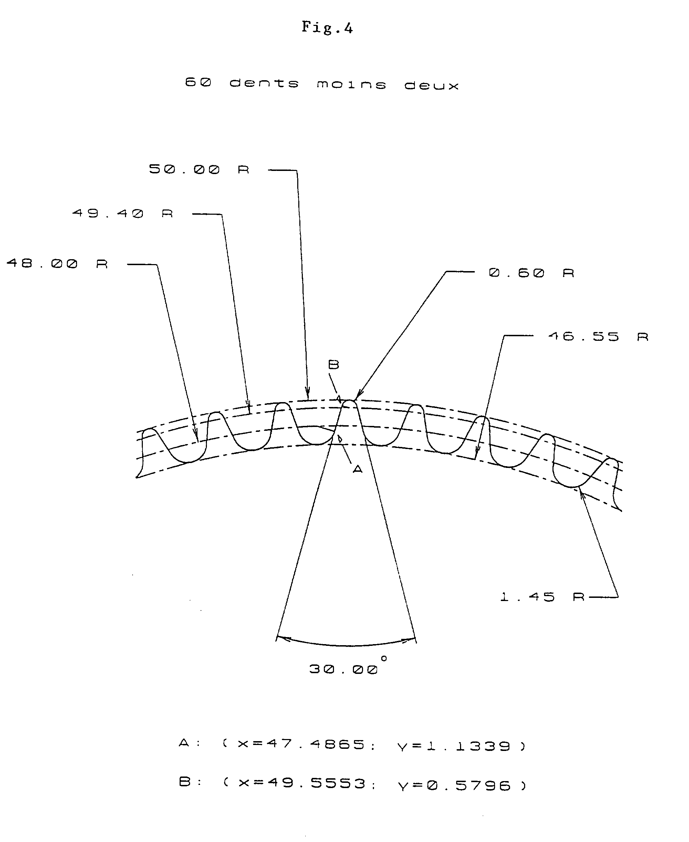

La figure 4 représente une vue en détail des dents.

L'angle formé par les deux flancs des dents est d'environ 30 degrés. La largeur du sommet de dent est de l'ordre de 1,5 millimètres, soit environ 30 % du pas. Le rayon moyen de la roue est de 48 millimètres, le rayon de l'enveloppe extérieure des dents est de 50 millimètres et le rayon de l'enveloppe des creux est de 46,55 millimètres. La roue présente 58 ou 59 dents identiques et une zone non dentée s'étendant sur un arc de cercle correspondant à la place occupée par une ou deux dents. Cette lacune constitue un repère de positionnement.

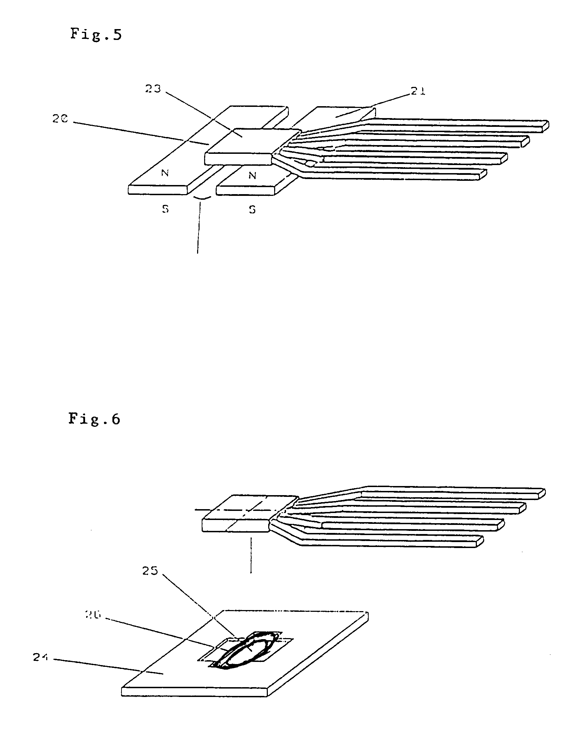

La figure 5 représente une vue en perspective d'un autre mode de réalisation de l'aimant. La solution selon ce mode de réalisation met en oeuvre 2 aimants (20, 21) disposés parallèlement, aimantés parallèlement à l'axe ZOZ'. La sonde de Hall (23) est collée sur les deux aimants (20, 21), à cheval sur un intervalle (22) prévu entre les deux aimants (20, 21). Ce mode de réalisation permet d'aménager un très faible intervalle entre les deux aimants, donc d'amener le point singulier suffisamment près de la surface de ces aimants.

La figure 6 représente une vue d'un troisième mode de réalisation de l'aimant. L'aimant (24) est de forme parallélépipédique. Il présente un trou (25) de section circulaire. L'aimant (25) présente par ailleurs des logements (26) pour le positionnement de la sonde de Hall ou du circuit intégré comportant cette sonde. L'aimant en samarium-cobalt avec un liant plastique est moulé avec une empreinte, par injection ou compression, ce qui permet d'obtenir de manière économique une forme de trou recherché et de réaliser un aimant électriquement isolant. L'aimant constitue le support de la "puce" de la sonde de Hall, l'ensemble étant surmoulé avec une résine.

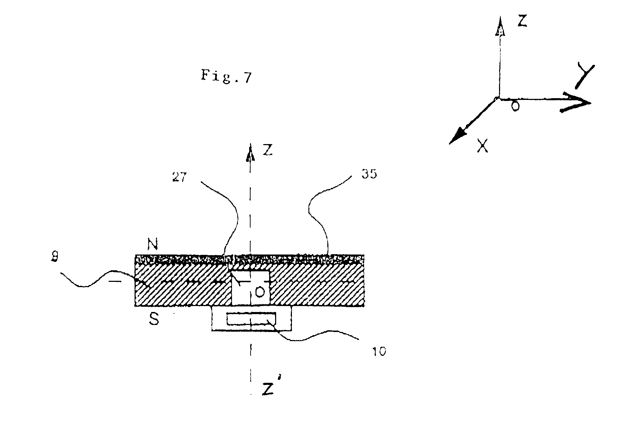

La figure 7 représente une vue en coupe d'un quatrième mode de réalisation.

L'aimant (9) est constitué par un disque d'un rayon R de 4,5 millimètres et d'une épaisseur L de 1,3 millimètres. L'aimant est du type métallique ou à liant plastique, tel que du samarium-cobalt 1/5, (par exemple les aimants commercialisés sous le nom commercial de Vacomax 145 ou 65K de la société VACUUMSCHMELTZE) ou 2/17 ou néodyme-fer-bore, )par exemple les aimants commercialisés sous le nom commercial de NEOFER 55/100p de la société MAGNETFABRIK BONN).

L'aimant présente une cavité cylindrique (27) coaxiale d'un rayon r de 0,5 millimètre et d'une profondeur p de 0,6 millimètre. Le volume occupé par la cavité (27) représente environ 1,2 % du volume global de l'aimant (9). Cette cavité peut être réalisée par moulage ou par tout procédé de perçage ou de rodage.

La sonde de Hall (10) est placée sur l'axe OZ perpendiculaire au plan médian (28) de l'aimant (9) à une distance z égale à 0,2 millimètre environ mesurée à partir de l'origine O.

Une culasse (35) est collée sur l'aimant (9). Cette culasse (35) est formée par une plaque cylindrique en un matériau magnétique doux de haute perméabilité magnétique. L'ensemble formé par l'aimant (9), la sonde de Hall (10), le circuit intégré et la culasse (35) est encapsulé dans une résine epoxy, une partie de la culasse dépassant et étant munie d'un trou pour la fixation.

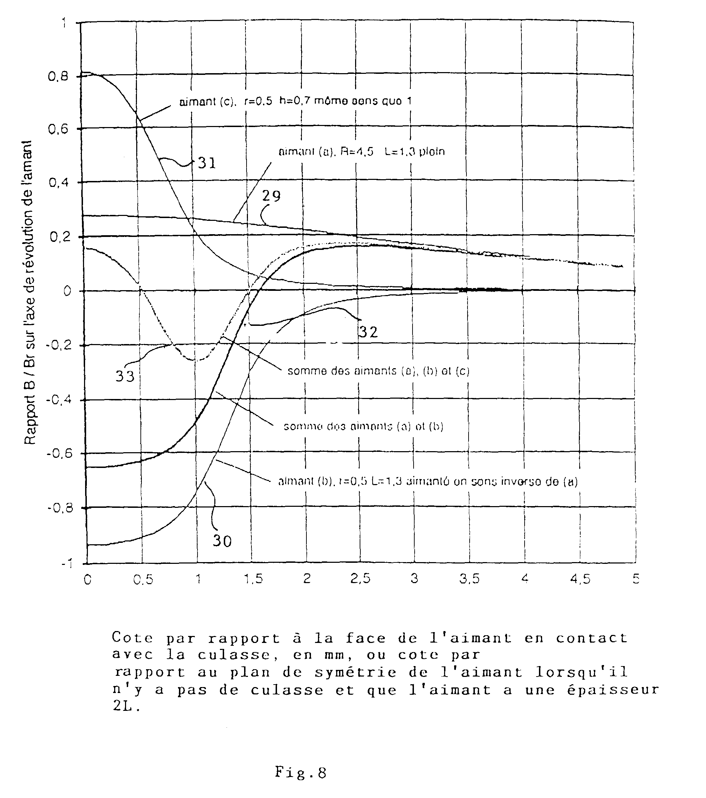

La figure 8 représente la courbe induction/cote par rapport à la face de l'aimant en contact avec la culasse selon le quatrième mode de réalisation.

La courbe (29) représente la variation de $B/B_r$ en fonction de la distance de la face de l'aimant en contact avec la culasse, d'un aimant formé par un cylindre plein de rayon R et d'épaisseur L.

La courbe (30) représente la variation de $B/B_r$ en fonction de la distance de la face de l'aimant en contact avec la culasse, d'un aimant virtuel formé par un cylindre plein de rayon r et d'épaisseur L aimanté en sens opposé de l'aimant (9).

La courbe (32) représente la variation de $B/B_r$ en fonction de la distance de la face de l'aimant en contact avec la culasse, d'un aimant formé par un cylindre plein de rayon R et d'épaisseur L percé par un trou de rayon r traversant toute l'épaisseur de l'aimant. On constate que l'induction s'annule en un point de l'axe OZ situé à une distance de 1,6 millimètres de la face de l'aimant en contact avec la culasse.

La courbe (33) représente la variation de $B/B_r$ en fonction de la distance, d'un aimant formé par un cylindre plein de rayon R et d'épaisseur L percé par une cavité de rayon r d'une profondeur 1. On constate que l'induction s'annule en un point de l'axe OZ situé à une distance de 0,5 millimètre de la face de l'aimant en contact avec la culasse.

Pour une variation donnée de distance de la dent en matériau magnétique doux, la modulation de B que l'on obtient avec l'aimant percé est pratiquement identique à celle que l'on obtient avec l'aimant plein, lorsque le volume du trou est très petit devant le volume de l'aimant.

Par contre, la valeur moyenne de l'induction est très différente. Elle est très faible avec l'aimant percé d'un petit trou, voire pratiquement nulle. Cela permet de mesurer l'induction B simplement avec un circuit intégré comportant une sonde de Hall sensible à des faibles inductions de l'ordre de 0 à ± 20mT telles que les circuits intégrés type TLE 4904 et 4905 de la société SIEMENS et non pas de manière plus coûteuse avec deux sondes distantes de quelques millimètres dont on mesure la différence des signaux.

Pour une valeur moyenne nulle de l'induction, une variation de température ou de qualité de l'aimant, ou même d'aimantation (qui influencent $B_r$) ne change en rien la valeur moyenne. Seule l'amplitude de la modulation change. Cette caractéristique permet de grandes tolérances de fabrication sans qu'il ne soit nécessaire de recourir à des sondes différentielles. La valeur moyenne n'est déterminée que par la géométrie du système. Dans le cas où la valeur moyenne est faible mais non nulle, l'influence d'une variation de température ou de qualité de l'aimant reste négligeable.

Une bonne adaptation de l'aimant au circuit intégré associé à la sonde de Hall est recherchée, afin que la valeur moyenne du champ mesuré soit très voisine de la valeur moyenne du champ de basculement. A cet effet, une des solutions consiste à procéder à un ajustement de l'aimant à l'aide d'un tir laser selon l'axe OZ, par l'arrière de l'aimant, lorsque le circuit intégré et la sonde sont en fonctionnement. Il est ainsi possible d'obtenir de bonnes performances sans avoir à recourir à des circuits intégrés avec des points de basculement situés dans des tolérances très étroites.

Lorsque la culasse n'est pas percée d'un petit trou dans l'axe OZ l'ajustement se fait en vaporisant de la matière magnétique douce;

Lorsque la culasse est percée d'un petit trou de dimension transversale au plus égale à celui de la cavité, l'ajustement se fait en vaporisant un peu d'aimant. Cette solution est préférable dans le cas d'un trou borgne. Pour cela, il est bien sûr nécessaire d'avoir prévu une valeur par excès de l'épaisseur 1 de l'aimant au fond du trou.

L'invention est décrite dans l'exemple qui précède dans une configuration circulaire. Il est bien entendu que l'homme du métier pourra facilement transposer l'invention à un mode de réalisation linéaire dans lequel les dents sont alignées linéairement. L'organe mobile pourra également être réalisé par une jante emboutie percée de trous rectangulaires.

**Revendications**

1. Capteur incrémental de position et/ou de vitesse, du type comportant un élément mobile (1) en un matériau doux présentant au moins une dent mobile selon un axe OY en regard d'un aimant permanent (9) aimanté selon un axe OZ sensiblement perpendiculaire à l'axe OY et une sonde (10) sensible au sens et à l'intensité d'un champ magnétique, telle qu'une sonde de Hall, disposée dans l'entrefer compris entre l'aimant (9) et la dent de l'élément mobile de telle sorte que son axe de plus grande sensibilité soit sensiblement orienté selon l'axe OZ, le capteur étant dimensionné de telle sorte que la sonde de Hall (10) est située à proximité d'un point singulier de l'axe OZ défini par la présence d'un champ nul, en un point où la valeur moyenne du champ magnétique suivant OZ au cours du déplacement de l'élément mobile est faible, le capteur étant caractérisé en ce que ladite valeur est de préférence inférieure à ± 20 mT et est sensiblement égale au champ entraînant le basculement d'un circuit intégré associé à la sonde de Hall, et en ce que le plan de la couche de Hall de la sonde de Hall est disposé entre le plan passant par la face frontale de l'aimant la plus proche de l'élément mobile, et le plan parallèle tangent à l'élément mobile, à une distance du plan frontal de l'aimant au moins égale à l'épaisseur de l'enveloppe de protection de la couche de Hall.

2. Capteur incrémental de position et/ou de vitesse selon la revendication 1 caractérisé en ce que l'aimant présente une cavité située à proximité de l'axe perpendiculaire à l'axe de déplacement de l'élément mobile passant par la sonde de Hall (10).

3. Capteur incrémental de position et/ou de vitesse selon la revendication 2 caractérisé en ce que ladite cavité est un petit trou.

4. Capteur incrémental de position et/ou de vitesse selon la revendication 2 caractérisé en ce que l'aimant est constitué par un aimant de forme discale percé ou évidé par une cavité cylindrique coaxiale.

5. Capteur incrémental de position et/ou de vitesse selon la revendication 4 caractérisé en ce que la sonde de Hall est positionnée à une ordonnée z sur l'axe OZ telle que l'induction

$$\frac{B_{Total}}{B_r} = \frac{B_{aimant\_plein}}{B_r} - \frac{B_{aimant\text{-}virtuel}}{B_r} + \frac{B_{aimant\_bouchon}}{B_r}$$

soit sensiblement égale à la valeur de basculement du circuit électronique intégré associée à la sonde de Hall lorsque l'entrefer augmente,

où :

- $B_{total}$ est la composante de l'induction suivant OZ ;
- l'origine O des axes à partir de laquelle est mesurée la distance z se trouve sur la face de l'aimant la plus proche de la dent;
- $B_r$ désigne l'induction rémanente ;
- $B_{aimant\_plein}$ désigne l'induction d'un aimant virtuel non percé, notamment cylindrique, dont les dimensions extérieures correspondent aux dimensions extérieures de l'aimant permanent ;
- $B_{aimant\_virtuel}$ désigne l'induction d'un aimant virtuel dont les dimensions extérieures correspondent aux dimensions intérieures de la cavité ;

- B$_{aimant\_bouchon}$ désigne l'induction d'un aimant virtuel dont la section correspond à la section intérieure de la cavité, et dont la hauteur correspond à la différence entre l'aimant réel et la profondeur de la cavité.

**6.** Capteur incrémental de position et/ou de vitesse selon la revendication 4 caractérisé en ce que la sonde de Hall est positionnée à une ordonnée z sur l'axe OZ telle que l'induction satisfait à :

$$\frac{B_{basculement}}{B_r} \cong \frac{1}{2}\left[\frac{z+2L}{\sqrt{R^2+(z+2L)^2}} - \frac{z}{\sqrt{R^2+z^2}} - \frac{z+2L}{\sqrt{r^2+(z+2L)^2}} + \frac{z}{\sqrt{r^2+z^2}} + \frac{(z+2l)}{\sqrt{r^2+(z+2l)^2}} - \frac{z}{\sqrt{r^2+z^2}}\right]$$

où :

- B$_{basculement}$ désigne la valeur du champ de basculement de la sonde de Hall ;
- l désigne la différence entre l'épaisseur de l'aimant et la profondeur de la cavité, l étant nul dans le cas d'un trou traversant l'aimant ;
- L désigne l'épaisseur de l'aimant dans le cas où l'aimant est associé à une culasse de grandes dimensions, la culasse jouant alors le rôle de miroir magnétique; si l'aimant n'est pas associé à une culasse, l'épaisseur de l'aimant est 2L ;
- z désigne l'ordonnée de la sonde de Hall mesurée à partir d'une origine située sur la face de l'aimant en regard de la denture ;
- R désigne le rayon extérieur de l'aimant ;
- r désigne le rayon de la cavité ou du trou cylindrique.
- B$_r$ désigne l'induction rémanente ;

**7.** Capteur incrémental de position et/ou de vitesse selon la revendication 1 ou 2 caractérisé en ce qu'il comporte deux aimants (21, 23) parallélépipédiques parallèles séparés par un intervalle mince (22) d'au plus 1,8mm prévu entre les deux aimants (20, 21) et dirigé suivant le plan XOY.

**8.** Capteur incrémental de position et/ou de vitesse selon l'une quelconque des revendications précédentes caractérisé en ce que l'élément mobile est une roue dentée.

**9.** Capteur incrémental de position et/ou de vitesse selon l'une quelconque des revendications 1 à 7 caractérisé en ce que l'élément mobile est une crémaillère.

**10.** Capteur incrémental de position et/ou de vitesse selon l'une quelconque des revendications 2 à 9 caractérisé en ce que l'aimant (9) est un aimant disque dont le rapport du diamètre à l'épaisseur est compris entre 4 et 7.

**11.** Capteur incrémental de position et/ou de vitesse selon la revendication 10 caractérisé en ce que l'aimant est un aimant discal comportant une cavité borgne coaxiale dont le diamètre est compris entre 0,8 et 1,8 mm, et de préférence entre 0,8 et 1,3 mm.

**12.** Capteur incrémental de position et/ou de vitesse selon l'une quelconque des revendications précédentes caractérisé en ce que l'aimant (9) est d'un type à faible coefficient de température, par exemple en samarium-cobalt orienté à liant plastique.

**13.** Capteur incrémental de position et/ou de vitesse selon l'une quelconque des revendications précédentes caractérisé en ce que le volume de la cavité ménagée dans l'aimant (9) est inférieur à 5% du volume de l'aimant (9).

**14.** Capteur incrémental de position et/ou de vitesse selon l'une quelconque des revendications précédentes caractérisé en ce que l'aimant (9), la sonde de Hall (10), éventuellement la culasse (35) et les circuits électroniques associés sont intégrés dans un boîtier en matière plastique réalisé par surmoulage.

**15.** Procédé pour l'adaptation de l'aimant au circuit intégré associé à la sonde de Hall d'un capteur selon l'une quelconque des revendications précédentes caractérisé en ce que l'on procède à un ajustement de l'aimant à l'aide d'un tir laser selon l'axe OZ, par l'arrière de l'aimant, lorsque le circuit intégré et la sonde sont en fonctionnement.

**Patentansprüche**

1. Inkrementaler Positions- und/oder Geschwindigkeitsgeber des Typs mit einem mobilen Element (1) aus einem weichen Werkstoff, das mindestens einen nach einer Achse OY mobilen Zahn gegenüber einem Dauermagneten (9) aufweist, der nach einer etwa lotrecht zur Achse OY verlaufenden Achse OZ magnetisiert ist, und eine gegenüber der Richtung und der Intensität eines Magnetfeldes empfindliche Sonde, wie beispielsweise eine Hall-Sonde, die im Luftspalt zwischen dem Magneten (9) und dem Zahn des mobilen Elementes angeordnet ist, so dass ihre empfindlichere Achse etwa nach der Achse OZ ausgerichtet ist, wobei der Geber so bemessen ist, dass die Hall-Sonde (10) sich in der Nähe eines bestimmten von der Anwesenheit eines Null-Feldes definierten Punktes der Achse OZ befindet, an einem Punkt, wo der Mittelwert des Magnetfeldes nach OZ während der Verschiebung des mobilen Elementes gering ist, wobei der Geber dadurch gekennzeichnet ist, dass der besagte Wert vorzugsweise kleiner als ± 20 mT und etwa gleich dem Feld ist, das die Umschaltung einer integrierten, der Hall-Sonde zugeordneten Schaltung bewirkt, und dass die Ebene der Hall-Schicht der Hall-Sonde zwischen der über die dem mobilen Element naheste Vorderseite des Magneten verlaufende Ebene und der parallelen, an das mobile Element angrenzenden Ebene angeordnet ist, in einem Abstand zur Vorderebene des Magneten von mindestens der Dicke des Schutzmantels der Hall-Schicht.

2. Inkrementaler Positions- und/oder Geschwindigkeitsgeber nach Anspruch 1, dadurch gekennzeichnet, dass der Magnet einen Hohlraum aufweist, der sich in der Nähe der lotrecht zur Verschiebungsachse des mobilen Elementes über die Hall-Sonde (10) verlaufenden Achse befindet.

3. Inkrementaler Positions- und/oder Geschwindigkeitsgeber nach Anspruch 2, dadurch gekennzeichnet, dass der besagte Hohlraum ein kleines Loch ist.

4. Inkrementaler Positions- und/oder Geschwindigkeitsgeber nach Anspruch 2, dadurch gekennzeichnet, dass der Magnet aus einem scheibenförmigen Magneten besteht, der von einem koaxialen zylindrischen Hohlraum durchbohrt oder ausgehöhlt ist.

5. Inkrementaler Positions- und/oder Geschwindigkeitsgeber nach Anspruch 4, dadurch gekennzeichnet, dass die Hall-Sonde an einer Ordinate z auf der Achse OZ angeordnet ist, so dass die Induktion

$$\frac{B_{total}}{B_e} = \frac{B_{voller\_Magnet}}{B_r} - \frac{B_{virtueller\_Magnet}}{B_r} + \frac{B_{verschlussmagnet}}{B_R}$$

etwa dem Umschaltwert der der Hall-Sonde zugeordneten integrierten elektronischen Schaltung entspricht, wenn der Luftspalt grösser wird, wobei :

- $B_{total}$ die Induktionskomponente nach OZ ist ;
- der Ursprung 0 der Achsen, ab dem der Abstand z gemessen wird, sich an der Seite des Magneten befindet, die dem Zahn am nahesten ist ;
- $B_r$ die remanente Induktion bezeichnet ;
- $B_{voller\_Magent}$ die Induktion eines virtuellen, ungelochten, insbesondere zylindrischen Magneten bezeichnet, dessen Aussenabmessungen den Aussenabmessungen des Dauermagneten entsprechen ;
- $B_{virtueller\_Magent}$ die Induktion eines virtuellen Magneten bezeichnet, dessen Aussenabmessungen den Innenabmessungen des Hohlraumes entsprechen ;
- $B_{verschlussmagnet}$ die Induktion eines virtuellen Magneten bezeichnet, dessen Querschnitt dem Innenquerschnitt des Hohlraumes entspricht, und dessen Höhe der Differenz zwischen dem reellen Magneten und der Tiefe des Hohlraumes entspricht.

6. Inkrementaler Positions- und/oder Geschwindigkeitsgeber nach Anspruch 4, dadurch gekennzeichnet, dass die Hall-Sonde an einer Ordinate z auf der Achse OZ angeordnet ist, so dass die Induktion folgender Formel entspricht :

$$B_{umschaltung} \cong \frac{1}{2}\left[ \frac{z+2L}{\sqrt{R^2+(z+2L)^2}} - \frac{z}{\sqrt{R^2+z^2}} - \frac{z+2L}{\sqrt{r^2+(z+2L)^2}} + \frac{z}{\sqrt{r^2+z^2}} + \frac{(z+2l)}{\sqrt{r^2+(z+2l)^2}} - \frac{z}{\sqrt{r^2+z^2}} \right]$$

wobei:

- $B_{umschaltung}$ den Wert des Umschaltfeldes der Hall-Sonde bezeichnet ;

  $B_r$ die remanente Induktion bezeichnet ;

- I die Differenz zwischen der Dicke des Magnets und der Tiefe des Hohlraumes bezeichnet, wobei 1 null beträgt, wenn der Magnet von einem Loch durchquert wird ;
- L die Dicke des Magneten bezeichnet, wenn der Magnet einem grossen Poljoch zugeordnet ist, das dann die Rolle eines Magnetspiegels spielt ; ist der Magnet keinem Poljoch zugeordnet, beträgt die Dicke des Magnets 2L ;
- z die Ordinate der Hall-Sonde bezeichnet, gemessen ab einem an der dem Zahn gegenüberliegenden Seite des Magnets befindlichen Ursprung ;
- R den Aussenradius des Magnets bezeichnet ;
- r den Radius des Hohlraumes oder des zylindrischen Loches bezeichnet.

7. Inkrementaler Positions- und/oder Geschwindigkeitsgeber nach Anspruch 1 oder 2, dadurch gekennzeichnet, dass er zwei quaderförmige, parallele Magneten (21, 23) umfasst, die von einem schmalen Zwischenraum (22) von mindestens 1,8 mm getrennt sind, der zwischen den beiden Magneten (20, 21) vorgesehen und nach der Ebene XOY ausgerichtet ist.

8. Inkrementaler Positions- und/oder Geschwindigkeitsgeber nach einem der vorstehend genannten Ansprüche, dadurch gekennzeichnet, dass das mobile Element ein Zahnrad ist.

9. Inkrementaler Positions- und/oder Geschwindigkeitsgeber nach einem der Ansprüche 1 bis 7, dadurch gekennzeichnet, dass das mobile Element eine Zahnstange ist.

10. Inkrementaler Positions- und/oder Geschwindigkeitsgeber nach einem der Ansprüche 2 bis 9, dadurch gekennzeichnet, dass der Magnet (9) ein Scheibenmagnet ist, dessen Verhältnis zwischen Durchmesser und Dicke zwischen 4 und 7 beträgt.

11. Inkrementaler Positions- und/oder Geschwindigkeitsgeber nach Anspruch 10, dadurch gekennzeichnet, dass der Magnet ein Scheibenmagnet ist, mit einem koaxialen Blindhohlraum, dessen Durchmesser zwischen 0,8 und 1,8 mm, und vorzugsweise zwischen 0,8 und 1,3 mm beträgt.

12. Inkrementaler Positions- und/oder Geschwindigkeitsgeber nach einem der vorstehend genannten Ansprüche, dadurch gekennzeichnet, dass der Magnet (9) eines Typs mit geringem Temperaturkoeffizienten ist, beispielsweise aus orientiertem Samarium-Kobalt mit Plastikbindemittel.

13. Inkrementaler Positions- und/oder Geschwindigkeitsgeber nach einem der vorstehend genannten Ansprüche, dadurch gekennzeichnet, dass das Volumen des im Magneten (9) vorgesehenen Hohlraumes kleiner ist als 5 % des Volumens des Magneten (9).

14. Inkrementaler Positions- und/oder Geschwindigkeitsgeber nach einem der vorstehend genannten Ansprüche, dadurch gekennzeichnet, dass der Magnet (9), die Hall-Sonde (10), eventuell das Poljoch (35) und die zugeordneten Elektronikschaltungen in einem durch Abformung hergestellten Kunststoffgehäuse integriert sind.

15. Verfahren zur Anpassung des Magneten an die integrierte, der Hall-Sonde zugeordneten Schaltung eines Gebers nach einem der vorstehend genannten Ansprüche, dadurch gekennzeichnet, dass man den Magneten mittels eines Laserschusses nach der Achse OZ von der Rückseite des Magneten aus anpasst, wenn die integrierte Schaltung und die Sonde in Betrieb sind.

## Claims

1. Incremental position and/or speed sensor of the type comprising a moving element (1) made from a soft material with at least one tooth free to move along an OY axis facing a permanent magnet (9) magnetized along an OZ axis approximately perpendicular to the OY axis and a probe (10) sensitive to the direction and intensity of a magnetic field such as a Hall probe, placed in the air gap between the magnet (9) and the tooth of the moving element such that the axis along which it is most sensitive is approximately parallel to the OZ axis, the size of the sensor being such that the Hall probe (10) is located approximately at a singular point along the OZ axis defined by the presence of a zero field, at a point at which the average value of the magnetic field along OZ during the displacement of the moving element is low, the sensor being characterized in that the said value is preferably less than ±20 mT and is approximately equal to the field necessary to switch an integrated circuit associated with the Hall probe, and in that the plane of the Hall layer of the Hall probe is located between the plane passing through the front surface of the magnet closest to the moving element, and the parallel plane tangent to the moving element, at a distance from the front plane of the magnet equal to at least the thickness of the Hall layer protective envelope.

2. Incremental position and/or speed sensor according to claim 1 characterized in that the magnet has a cavity located close to the axis perpendicular to the axis of displacement of the moving element passing through the Hall probe (10).

3. Incremental position and/or speed sensor according to claim 2 characterized in that the said cavity is a small hole.

4. Incremental position and/or speed sensor according to claim 2 characterized in that the magnet is composed of a disk-shaped magnet in which a coaxial cylindrical cavity or hole is formed.

5. Incremental position and/or speed sensor according to claim 4 characterized in that the Hall probe is located at an ordinate z on the OZ axis such that the induction

$$\frac{B_{Total}}{B_r} = \frac{B_{solid\_magnet}}{B_r} - \frac{B_{virtual\_magnet}}{B_r} + \frac{B_{plug\_magnet}}{B_r}$$

is approximately equal to the switching value of the integrated electronic circuit associated with the Hall probe when the air gap increases,
   in which:

- $B_{total}$ is the component of the induction along OZ;
- The origin O of the axes from which the distance z is measured is located on the magnet surface closest to the tooth;
- $B_r$ is the remanent induction;
- $B_{solid\_magnet}$ is the induction of a virtual unperforated magnet, particularly cylindrical, which has the same outside dimensions as the outside dimensions of the permanent magnet;
- $B_{virtual\_magnet}$ is the induction of a virtual magnet, which has the same outside dimensions as the inside dimensions of the cavity;
- $B_{plug\_magnet}$ is the induction of a virtual magnet, the cross-section of which corresponds to the inside cross-section of the cavity, and the height of which is equal to the difference between the real magnet and the depth of the cavity.

6. Incremental position and/or speed sensor according to claim 4 characterized in that the Hall probe is located at an ordinate z on the OZ axis such that the induction satisfies:

$$\frac{B_{switching}}{B_r} \equiv \frac{1}{2}\left[\frac{2+2L}{\sqrt{R^2+(2+2L)^2}} - \frac{z}{\sqrt{R^2+z^2}} - \frac{z+2L}{\sqrt{r^2+(z+2L)^2}} + \frac{z}{\sqrt{r^2=z^2}} + \frac{(z+2l)}{\sqrt{r^2+(z+2l)^2}} - \frac{z}{\sqrt{r^2+z^2}}\right]$$

where:

- $B_{switching}$ is the value of the switching field of the Hall probe;
- $B_r$ is the remanent induction;
- l is the difference between the thickness of the magnet and the cavity depth, and is zero in the case of a hole passing through the magnet;
- L is the thickness of the magnet when the magnet is associated with a large yoke, the yoke then acting as a magnetic mirror; if the magnet is not associated with a yoke, the magnet thickness is 2L;
- z is the ordinate of the Hall probe measured starting from an origin located on the magnet surface facing the tooth;

- R is the outside radius of the magnet;
- r is the radius of the cavity or the cylindrical hole.

7. Incremental position and/or speed sensor according to claim 1 or 2 characterized in that it comprises two parallel parallelepiped-shaped magnets (21, 23) separated by a thin interval (22) not more than 1.8 mm between two magnets (20, 21) and directed along the XOY plane.

8. Incremental position and/or speed sensor according to any one of the previous claims, characterized in that the moving element is a toothed wheel.

9. Incremental position and/or speed sensor according to any one of claims 1 to 7, characterized in that the moving element is a rack.

10. Incremental position and/or speed sensor according to any one of claims 2 to 9, characterized in that the magnet (9) is a disk magnet in which the ratio of the diameter to the thickness is between 4 and 7.

11. Incremental position and/or speed sensor according to claim 10, characterized in that the magnet is a disk-shaped magnet with a coaxial non-through cavity, the diameter of which is between 0.8 and 1.8 mm and preferably between 0.8 and 1.3 mm.

12. Incremental position and/or speed sensor according to any one of the previous claims, characterized in that the magnet (9) has a low temperature coefficient, and is made for example from oriented samarium-cobalt with a plastic binder.

13. Incremental position and/or speed sensor according to any one of the previous claims, characterized in that the volume of the cavity formed in the magnet (9) is less than 5% of the volume of the magnet (9).

14. Incremental position and/or speed sensor according to any one of the previous claims, characterized in that magnet (9), the Hall probe (10), the yoke (35) if any and the associated electronic circuits are integrated inside a plastic housing made by insert-molding.

15. Process for adaptation of the magnet to the integrated circuit associated with the Hall probe in a sensor according to any one of the previous claims, characterized in that the magnet is adjusted by laser firing along the OZ axis through the back of the magnet when the integrated circuit and the probe are in operation.

Fig.1

Fig.2

Fig.3

Fig.4

60 dents moins deux

50.00 R

49.40 R

48.00 R

0.60 R

16.55 R

B

A

1.45 R

30.00°

A : ( x=47.4865 ; Y=1.1339 )

B : ( x=49.5553 ; Y=0.5796 )

Fig.5

Fig.6

Fig.7

Fig.8